# EUROPEAN PATENT SPECIFICATION

(11) **EP 2 889 967 B1**
(45) Date of publication and mention of the grant of the patent: **07.03.2018**
(21) Application number: 14020120.3
(22) Date of filing: 22.12.2014
(51) Int. Cl.: H01S 5/00, H01S 5/0687, H03B 17/00

(54) **Method for the frequency regulation and stabilisation of an optoelectronic oscillator**
Verfahren zur Frequenzregelung und Stabilisierung eines optoelektronischen Oszillators
Procédé pour la stabilisation et la régulation de la fréquence d'un oscillateur optoélectronique

(30) Priority: 24.12.2013 SI 201300448
(43) Date of publication of application: 01.07.2015
(73) Proprietor: Univerza v Ljubljani Fakulteta za elektrotehniko, 1000 Ljubljana (SI); Center odlicnosti za biosenzoriko, instrumentacijo in procesno kontrolo, 5720 Ajdovscina (SI)
(72) Inventor: Bogataj, Luka, 4228 Zelezniki (SI); Vidmar, Matjaz, 5000 Nova Gorica (SI); Batagelj, Bostjan, 1000 Ljubljana (SI); Tratnik, Jurij, 1290 Grosuplje (SI)
(74) Representative: Ivancic, Bojan

(56) References cited:
- WO-A1-2013/117199
- WO-A2-2005/055412
- US-A1- 2004 109 217
- US-B1- 7 697 579
- FRIEDERIKE BRENDEL ET AL: "A novel technique for sideband stabilization in the presence of carrier phase noise in RoF systems", MICROWAVE CONFERENCE (EUMC), 2012 42ND EUROPEAN, IEEE, 29 October 2012 (2012-10-29), pages 550-553, XP032328309, ISBN: 978-1-4673-2215-7
- MASASHI MIZUMA ET AL: "RF-down and RF-up converting optoelectronic oscillator for spurious suppression", MICROWAVE SYMPOSIUM DIGEST (MTT), 2012 IEEE MTT-S INTERNATIONAL, IEEE, 17 June 2012 (2012-06-17), pages 1-3, XP032216834, DOI: 10.1109/MWSYM.2012.6258398 ISBN: 978-1-4673-1085-7
- PAN S ET AL: "Wideband and frequency-tunable microwave generation using an optoelectronic oscillator incorporating a Fabry?Perot laser diode with external optical injection", OPTICS LETTERS, OPTICAL SOCIETY OF AMERICA, vol. 35, no. 11, 30 June 2010 (2010-06-30) , pages 1911-1913, XP001554403, ISSN: 0146-9592, DOI: 10.1364/OL.35.001911 [retrieved on 2010-05-28]

## Description

The present invention relates to a method for the frequency regulation and stabilisation of an optoelectronic oscillator comprising an optical section with a light source and an electrical section, wherein the said optical section, for example, comprises a modulated light source, from which a fibre leads to a photo detector, and wherein the electrical section, for example, comprises an amplifier in a series connected to said photo detector, a band-pass filter and a splitter of the electrical signal at the output of the oscillator and a modulation input of said light source.

An optoelectronic oscillator of the above identified type has been disclosed in US 2994/109217 A1, WO 2005/055412 A2, and US 7 697 579 B1, wherein said known solutions have a problem with a long-term frequency instability. Other optoelectronic oscillators are e.g. presented in Friederike Brendel et al., "A novel technique for sideband stabilization in the presence of carrier phase noise in RoF systems", Microwave Conference (EUMC), IEEE, 29 October 2012 , pages 550-553 and Masashi Mizuma et al, "RF-down and RF-up converting optoelectronic oscillator for spurious suppression", Microwave Symposium Digest (MTT), IEEE, 17 June 2012, pages 1-3. The frequency of said oscillator is influenced by many factors from the oscillator's surroundings, such as the ambient temperature. All known solutions attempt to eliminate the frequency stabilisation problem by way of stabilising the surroundings of the oscillator. Such solutions are often impractical and pose an obstacle to use of the optoelectronic oscillator. In addition, similar solution has been disclosed in Article to Brendel et al. Said Article teaches how to stabilize the sidebands with unstable sources. Furthermore, Article to Mizuma et al Furthermore teaches how to suppress higher-order side-modes by means of mixing to a lower frequency and re-mixing to a higher frequency, which might be efficient for suppression of higher-order oscillation modes, however, it is inefficient in order to stabilize the oscillator.

It is the object of the present invention to provide a method to regulate and stabilise the frequency of an optoelectronic oscillator, thus remedying drawbacks of known solutions. According to the invention, the object as set above is solved by the features given in the characterising part of the claim 1. Details of the invention are disclosed in the sub-claims.

The invention is described in more detail on the basis of a non-limiting embodiment and with reference to the accompanying drawings, wherein:
- Fig. 1: shows a schematic view of the optoelectronic oscillator with frequency control according to the invention,
- Fig. 2: shows a more detailed view of the oscillator of Fig. 1.

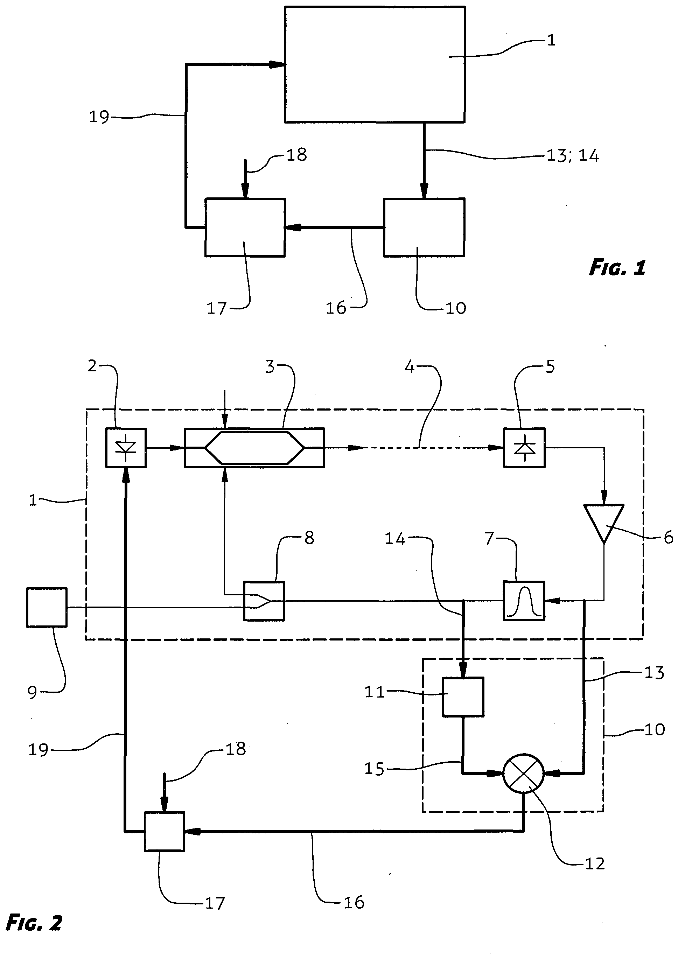

According to the invention, a method for the regulation and stabilisation of the optoelectronic oscillator known per se is described in the general embodiment, as shown in Fig. 1, where from an optoelectronic oscillator 1 whose frequency is to be regulated and stabilised signals 13; 14 is taken which is fed to a phase detector 10. Said signal 13; 14 is taken from any part of the oscillator 1, either an optical or an electrical section. In the present embodiment, the signal 13; 14 is taken from the electrical section at the input of a band-pass filter 7 and at the output of the band-pass filter 7. If the signal 13; 14 from the oscillator 1 is taken at the point where the band-pass filter is not present, then said phase detector 10 additionally comprises said filter. Namely, according to the present invention, measurement of the frequency is determined on the basis of how much the signal 13; 14 is phase shifted when passing the band-pass filter. A signal 16, exiting said phase detector 10, which carries information of the frequency, in the present embodiment the electrical voltage, enters a controller 17 of the wavelength of light source 2, wherein a reference signal 18 is simultaneously carried to said controller 17. Said controller 17 compares said signal 16 with the previously mentioned reference signal 18, and if there is a difference between the two signals 16, 18, said controller 17 changes the value of a control signal 19 sent to said oscillator 1. According to the present invention, it is provided that a loop which controls the wavelength of the light source 2 is mounted onto the optoelectronic oscillator 1, said loop being part of the oscillator 1. Said loop is designed in such a manner that the phase detector 10 measures the frequency of the output signal 13; 14 of the oscillator 1, wherein said detector 10 adapts the signal 16, the voltage for example, to said frequency. Said signal 16 enters the controller 17 of the wavelength of the light source 2, where it is compared to the reference signal 18. Based on said comparison, the controller 17 of the wavelength generates the control signal 19, which changes the wavelength of the light source 2 of the optoelectronic oscillator 1.

Fig. 2 shows a more detailed embodiment of the invention, wherein the optoelectronic oscillator 1 comprises the light source 2, for example a laser light source which transmits light to an operating point 3, from where the light travels along a fibre 4 to a photo detector 5. Said photo detector 5 converts the received light into an electrical signal, which is led via an amplifier 6 and the band-pass filter 7, which are mutually series-connected, to a splitter 8. The latter sends the first part of said signal to an output 9 of the oscillator and the second part of said signal to a modulation input of the working point 3.

In order to secure long-term frequency stabilisation of the oscillator 1, a feedback control loop is implemented by means of which a phase between the input and the output signal of the band-pass filter 7 is compared and the light source 2 is controlled. Said loop is formed in a manner that said band-pass filter 7 is connected in parallel to the phase detector 10, comprising in the present embodiment a phase shifter 11 and a frequency mixer 12. At the point directly before said input signal enters said band-pass filter 7, a first regulation signal 13 is taken and, at the point directly at the exit of said output signal from said band-pass filter 7, a second regulation signal 14 is taken, wherein said regulation signals 13, 14 are led to said phase detector 10. It is provided for according to the invention, that at least one signal 13; 14 is sufficient to carry out the method, said signal being taken at an arbitrary point of the oscillator 1, either in the optical section or in the electrical section. With the embodiment as described above, at first said second regulation signal 14 is led into said phase shifter 11 where the regulation signal 14 is phase shifted relative to said first regulation signal 13, preferably for the amount of *pi*/*2,* in order to obtain a phase shifted regulation signal 15, which is further led into said mixer 12. Said first regulation signal 13 is led directly into said mixer 12, where it combines with said phase shifted second regulation signal 15. The result of the merged signals 13, 15 is a signal 16 which carries information of the frequency, such as an electrical signal of a specific voltage for example, which is defined by the frequency of the oscillator 1. Afterwards, said signal 16 is led to the controller 17 of the wavelength of the light source 2, to a proportional integral regulator for example, where it is compared with the reference signal 18, which is the equivalent to the required frequency of the oscillator 1. If a difference exists between said reference signal 18 and said signal 16 entering from the phase detector 10 to said controller 17, said controller 17 changes the value of the control signal 19 being sent to said oscillator 1, thereby controlling the light source 2 and, respectively, changing the wavelength of the light source 2. In the present embodiment, when a laser is selected as light source 2, a change in said wavelength can be achieved, for example, by changing the temperature of the laser or the like.

## Claims

1. A method for the frequency regulation and stabilisation of an optoelectronic oscillator (1) comprising an optical section with a light source and an electrical section, a feedback control loop being associated with an optoelectronic oscillator, said control loop controlling the wavelength of the light source (2) of the oscillator, said electrical section comprising a photo detector (5) converting the received light into an electrical signal, which is led via an amplifier (6) and a band-pass filter (7), which are mutually series connected, to a splitter (8) that sends a first part of said signal to an output (9) of the optoelectronic oscillator, the frequency thereof is to be regulated and stabilised, and the second part of said signal to a modulation input of the working point (3) in the optical section, ***characterised in that*** said controlling of the wavelength of the light source (2) of the oscillator (1) comprises the following steps:
a) leading two signals from the input and the output of the band-pass filter (7), respectively, to a phase detector (10),
b) determining by means of said detector (10) the frequency of at least one of said signals (13; 14), wherein the said detector (10) assigns a first signal (16) to said frequency, said signal (16) carrying an information on the frequency,
c) leading the first signal (16) exiting said detector (10) to a controller (17) of the light source wavelength,
d) additional leading of a reference signal (18) to said controller (17),
e) comparing in said controller (17) the first signal (16) with said reference signal (18),
f) changing the value of a control signal (19) and, if a difference between the Z first signal (16) and the reference signal (18) is present, transmitting this modified control signal (19) to said oscillator (1).

2. A method according to claim 1, ***characterised in that*** the change in wavelength of the light source (2) is achieved by means of a change in the temperature of the light source (2).

3. A method according to claims 1 to 2, ***characterised in that*** said reference signal (18) is an equivalent to the required frequency of the oscillator (1).

4. A device for regulation and stabilisation of the frequency of an optoelectronic oscillator (1) comprising an optical section with a light source (2) and an electric section of the optoelectronic oscillator, a feedback control loop beeing associated with an optoelectronic oscillator, said control loop controlling the wavelength of the light source of the, said electrical section comprising a photo detector (5) converting the received light into an electrical signal (13), which is led via an amplifier (6) and a band-pass filter (7), which are mutually series connected, to a splitter (8) that sends a first part of said electrical signal to an output (9) of the optoelectronic oscillator, the frequency thereof is to be regulated and stabilised, and the second part of said electrical signal to a modulation input of the working point (3) in the optical section, ***characterised in that*** said feedback loop comprises a phase detector (10) into which two signals (13, 14) of the oscillator (1) are led from the input and the output of the band-pass filter (7), respectively, and from which a first signal (16) that carries information about the frequency is carried to a controller (17) of the wavelength of the light source (2), which is compared with a reference signal (18) and, depending on the result of the comparison, changes a control signal (19) and sends it to said light source (2).

5. A device for regulation and stabilisation of the frequency of an optoelectronic oscillator according to claims 4, ***characterised in that*** the phase detector (10) comprises a phase shifter (11) and a frequency mixer (12) and optionally a band-pass filter.

6. A device for regulation and stabilisation of the frequency of the optoelectronic oscillator according to claims 4 and 5, ***characterised in that*** the controller (17) of the wavelength of the light source (2) is selected as a proportional integral regulator.

## Patentansprüche

1. Verfahren zur Frequenzregelung und Stabilisierung eines optoelektronischen Oszillators (1), der eine optische Gruppe mit einer Lichtquelle und eine elektrische Gruppe beinhaltet, wobei ein Rückkopplungsregelkreis mit dem optoelektronischen Oszillator verbunden ist, wobei der Regelkreis die Wellenlänge der Lichtquelle (2) des Oszillators steuert, wobei die elektrische Gruppe einen Fotodetektor (5) umfasst, der das empfangene Licht in ein elektrisches Signal umwandelt, welches über einen Verstärker (6) und einen Bandpassfilter (7), die miteinander in Reihe geschaltet sind, an einen Splitter (8) weitergeleitet wird, der einen ersten Teil des Signals an einen Ausgang (9) des optoelektronischen Oszillators, dessen Frequenz reguliert und stabilisiert werden soll, sendet und den zweiten Teil des Signals an einen Modulationseingang des Arbeitspunkts (3) in der optischen Gruppe sendet, ***dadurch gekennzeichnet, dass*** die Steuerung der Wellenlänge der Lichtquelle (2) des Oszillators (1) die folgenden Schritte umfasst:
a) Übertragen von zwei Signalen entsprechend von dem Eingang und dem Ausgang des Bandpassfilters (7) zu einem Phasendetektor (10),
b) Bestimmen der Frequenz von wenigstens einem der Signale (13, 14) mithilfe des Detektors (10), wobei der Detektor (10) der Frequenz ein erstes Signal (16) zuordnet, wobei dieses Signal (16) eine Information bezüglich der Frequenz trägt,
c) Übertragen des ersten Signals (16), das den Detektor (10) verlässt, an eine Kontrollvorrichtung (17) der Lichtquellenwellenlänge,
d) zusätzliches Übertragen eines Referenzsignals (18) an die Kontrollvorrichtung (17),
e) Vergleichen des ersten Signals (16) mit dem Referenzsignal (18) in der Kontrollvorrichtung (17),
f) Ändern des Wertes eines Kontrollsignals (19) und, wenn ein Unterschied zwischen dem ersten Signal (16) und dem Referenzsignal (18) vorhanden ist, Übertragen dieses geänderten Kontrollsignals (19) an den Oszillator (1).

2. Verfahren nach Anspruch 1, ***dadurch gekennzeichnet, dass*** die Änderung der Wellenlänge der Lichtquelle (2) mittels einer Änderung der Temperatur der Lichtquelle (2) erzielt wird.

3. Verfahren nach einem der Ansprüche 1 und 2, ***dadurch gekennzeichnet, dass*** das Referenzsignal (18) ein Äquivalent zur gewünschten Frequenz des Oszillators (1) ist.

4. Vorrichtung zur Regulierung und Stabilisierung der Frequenz eines optoelektronischen Oszillators (1), der eine optische Gruppe mit einer Lichtquelle (2) und eine elektrische Gruppe des optoelektronischen Oszillators beinhaltet, wobei ein Rückkopplungsregelkreis mit dem optoelektronischen Oszillator verbunden ist, wobei der Regelkreis die Wellenlänge der Lichtquelle steuert, wobei die elektrische Gruppe einen Fotodetektor (5) umfasst, der das empfangene Licht in ein elektrisches Signal (13) umwandelt, welches über einen Verstärker (6) und einen Bandpassfilter (7), die miteinander in Reihe geschaltet sind, an einen Splitter (8) übertragen wird, der einen ersten Teil des elektrischen Signals an einen Ausgang (9) des optoelektronischen Oszillators, dessen Frequenz reguliert und stabilisiert werden soll, sendet und den zweiten Teil des elektrischen Signals an einen Modulationseingang des Arbeitspunkts (3) in der optischen Gruppe sendet, ***dadurch gekennzeichnet, dass*** der Regelkreis einen Phasendetektor (10) umfasst, zu welchem zwei Signale (13, 14) des Oszillators (1) entsprechend von dem Eingang und dem Ausgang des Bandpassfilters (7) übertragen werden und von dem ein erstes Signal (16), welches eine Information über die Frequenz trägt, an eine Kontrollvorrichtung (17) der Wellenlänge der Lichtquelle (2) übertragen wird und mit einem Referenzsignal (18) verglichen wird, wobei abhängig von dem Vergleichsergebnis ein Kontrollsignal (19) verändert wird und dieses an die Lichtquelle (2) gesendet wird.

5. Vorrichtung zur Regulierung und Stabilisierung der Frequenz eines optoelektronischen Oszillators nach Anspruch 4, ***dadurch gekennzeichnet, dass*** der Phasendetektor (10) einen Phasenschieber (11) und einen Frequenzmischer (12) und wahlweise einen Bandpassfilter umfasst.

6. Vorrichtung zur Regulierung und Stabilisierung der Frequenz eines optoelektronischen Oszillators nach einem der Ansprüche 4 und 5, ***dadurch gekennzeichnet, dass*** die Kontrollvorrichtung (17) der Wellenlänge der Lichtquelle (2) als ein Proportional - Integral - Regulator gewählt ist.

## Revendications

1. Procédé pour la stabilisation et la régulation de fréquence d'un oscillateur optoélectronique (1) comprenant une section optique avec une source de lumière et une section électrique, une boucle de commande à réaction étant associée à un oscillateur optoélectronique, ladite boucle de commande commandant la longueur d'onde de la source de lumière (2) de l'oscillateur, ladite section électrique comprenant un photodétecteur (5) convertissant la lumière reçue en un signal électrique, qui est acheminé par l'intermédiaire d'un amplificateur (6) et d'un filtre passe-bande (7), qui sont connectés mutuellement en série, jusqu'à un séparateur (8) qui envoie une première partie dudit signal à une sortie (9) de l'oscillateur optoélectronique, dont la fréquence doit être stabilisée et régulée, et la seconde partie dudit signal à une entrée de modulation du point de fonctionnement (3) dans la section optique, ***caractérisé par le fait que*** ladite commande de la longueur d'onde de la source de lumière (2) de l'oscillateur (1) comprend les étapes suivantes :
a) acheminer deux signaux de l'entrée et de la sortie du filtre passe-bande (7), respectivement, à un détecteur de phase (10),
b) déterminer, au moyen dudit détecteur (10), la fréquence d'au moins un desdits signaux (13 ; 14), ledit détecteur (10) attribuant un premier signal (16) à ladite fréquence, ledit signal (16) transportant des informations concernant la fréquence,
c) acheminer le premier signal (16) sortant du détecteur (10) jusqu'à une unité de commande (17) de la longueur d'onde de source de lumière,
d) acheminer également un signal de référence (18) jusqu'à ladite unité de commande (17),
e) comparer, dans ladite unité de commande (17), le premier signal (16) audit signal de référence (18),
f) changer la valeur d'un signal de commande (19) et, si une différence entre le premier signal (16) et le signal de référence (18) est présente, transmettre ce signal de commande modifié (19) audit oscillateur (1).

2. Procédé selon la revendication 1, ***caractérisé par le fait que*** le changement dans la longueur d'onde de la source de lumière (2) est obtenu au moyen d'un changement dans la température de la source de lumière (2).

3. Procédé selon les revendications 1 à 2, ***caractérisé par le fait que*** ledit signal de référence (18) est un équivalent à la fréquence requise de l'oscillateur (1).

4. Dispositif pour la stabilisation et la régulation de la fréquence d'un oscillateur optoélectronique (1) comprenant une section optique avec une source de lumière (2) et une section électrique de l'oscillateur optoélectronique, une boucle de commande à réaction étant associée à un oscillateur optoélectronique, ladite boucle de commande commandant la longueur d'onde de la source de lumière de l'oscillateur, ladite section électrique comprenant un photodétecteur (5) convertissant la lumière reçue en un signal électrique (13), qui est acheminé par l'intermédiaire d'un amplificateur (6) et d'un filtre passe-bande (7), qui sont connectés mutuellement en série, jusqu'à un séparateur (8) qui envoie une première partie dudit signal électrique à une sortie (9) de l'oscillateur optoélectronique, dont la fréquence doit être stabilisée et régulée, et la seconde partie dudit signal électrique à une entrée de modulation du point de fonctionnement (3) dans la section optique, ***caractérisé par le fait que*** ladite boucle à réaction comprend un détecteur de phase (10) dans lequel deux signaux (13, 14) de l'oscillateur (1) sont acheminés depuis l'entrée et la sortie du filtre passe-bande (7), respectivement, et à partir duquel un premier signal (16) qui transporte des informations concernant la fréquence est acheminé jusqu'à une unité de commande (17) de la longueur d'onde de la source de lumière (2), qui est comparé à un signal de référence (18) et, selon le résultat de la comparaison, change un signal de commande (19) et l'envoie à ladite source de lumière (2).

5. Dispositif pour la stabilisation et la régulation de la fréquence d'un oscillateur optoélectronique selon la revendication 4, ***caractérisé par le fait que*** le détecteur de phase (10) comprend un déphaseur (11) et un mélangeur de fréquences (12) et éventuellement un filtre passe-bande.

6. Dispositif pour la stabilisation et la régulation de la fréquence de l'oscillateur optoélectronique selon les revendications 4 et 5, ***caractérisé par le fait que*** l'unité de commande (17) de la longueur d'onde de la source de lumière (2) est choisie en tant que régulateur proportionnel intégral.
